# EUROPEAN PATENT APPLICATION

(11) **EP 4 503 110 A2**
(43) Date of publication of application: **05.02.2025**
(21) Application number: 24188311.5
(22) Date of filing: 12.07.2024
(51) Int. Cl.: H01L 21/763, H01L 21/768

(54) **OPTIMAL HIGH VOLTAGE TUB DESIGN WITH FLOATING POLY TRENCHES**

(30) Priority: 01.08.2023 US 202318228934
(71) Applicant: NXP B.V., 5656 AG Eindhoven (NL)
(72) Inventor: Mehrotra, Saumitra Raj, 5656AG Eindhoven (NL); Boyd, James Gordon, 5656AG Eindhoven (NL); Boon, Gerben, 5656AG Eindhoven (NL); Nijland, Gerrit Willem, 5656AG Eindhoven (NL); Zhu, Ronghua, 5656AG Eindhoven (NL); Roggenbauer, Todd, 5656AG Eindhoven (NL)
(74) Representative: Schmütz, Christian Klaus Johannes

(57) **Abstract**

A method and apparatus are disclosed for an integrated circuit having a high voltage tub including a buried layer of a first conductivity type formed in a substrate of a second conductivity type, a central region of the first conductivity type formed in the substrate in contact with the buried layer, a first floating isolation trench formed in the substrate to surround the central region and to extend down to and surround the buried layer, a second floating isolation trench formed in the substrate around the first isolation trench, a shallow ring region of the first conductivity type formed in the substrate between the first floating isolation trench and the second floating isolation trench, a first conductive interconnect structure for electrically shorting the central region to the shallow ring region, and a second conductive interconnect structure for electrically shorting the first floating isolation trench to the second floating isolation trench.

## Description

### BACKGROUND OF THE INVENTION

### Field of the Invention

The present disclosure is directed in general to the field of semiconductor devices. In one aspect, the present disclosure relates to integrated circuit devices and processes for integrating analog components, digital components and high voltage devices into a single chip or integrated circuit.

### Description of the Related Art

Electronic devices, especially semiconductor devices and integrated circuits, often include multiple, separate semiconductor-based components fabricated on the same semiconductor substrate or die. The components are typically designed to operate independently from one another so that they do not interfere or latch up with neighboring components. To provide electrical isolation between different components, deep trench isolation (DTI) structures and/or high voltage regions may be used in semiconductor devices to electrically isolate laterally and vertically adjacent regions of a substrate. In addition, trench-based isolation techniques are used with silicon-on-insulator wafers to eliminate latch up risk. However, as the operating voltage and component density (components per unit area) on the substrate increase, it becomes increasingly difficult to maintain the desired isolation breakdown voltage. In addition, with shrinking device sizes, junction-based isolation techniques require too much silicon area, and trench-based isolation techniques on SOI wafers are too expensive. And with increased packing density of semiconductor components, there are wider variations in the distribution of breakdown voltages observed across a die or wafer which can lead to lower manufacturing yields. As seen from the foregoing, the existing solutions for providing isolation between different or neighboring devices formed on a shared substrate are extremely difficult at a practical level by virtue of the challenges with providing effective isolation structures while meeting the performance requirements and cost constraints for mass production of semiconductor devices and avoiding the performance and reliability related problems associated with conventional isolation structures.

### BRIEF DESCRIPTION OF THE DRAWINGS

The present disclosure may be understood, and its numerous objects, features and advantages obtained, when the following detailed description of a preferred embodiment is considered in conjunction with the following drawings.

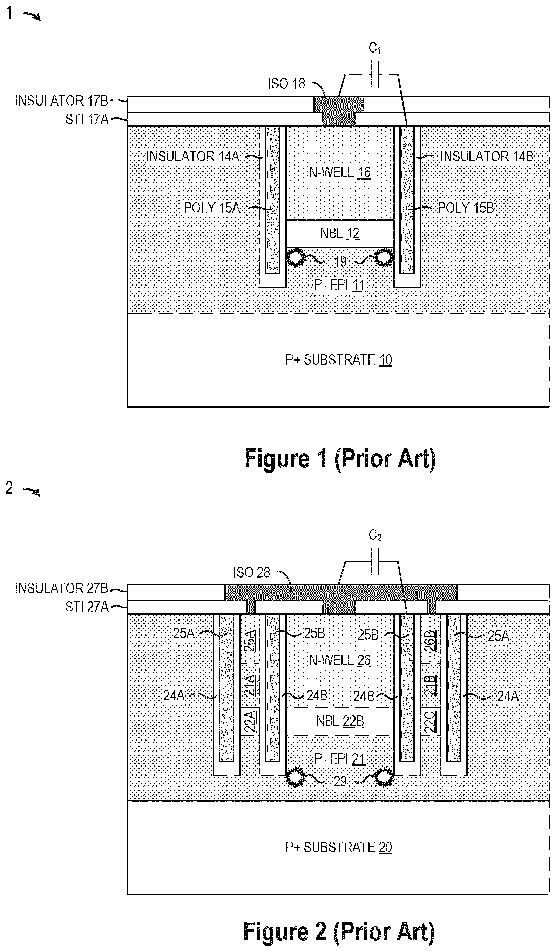

Figure 1 depicts a simplified cross-sectional view of an integrated circuit employing a prior art isolation structure wherein a single conductive buried layer intersects with a poly-filled deep trench.
Figure 2 depicts a simplified cross-sectional view of an integrated circuit employing a prior art isolation structure wherein a single conductive buried layer intersects with concentric poly-filled deep trench rings.

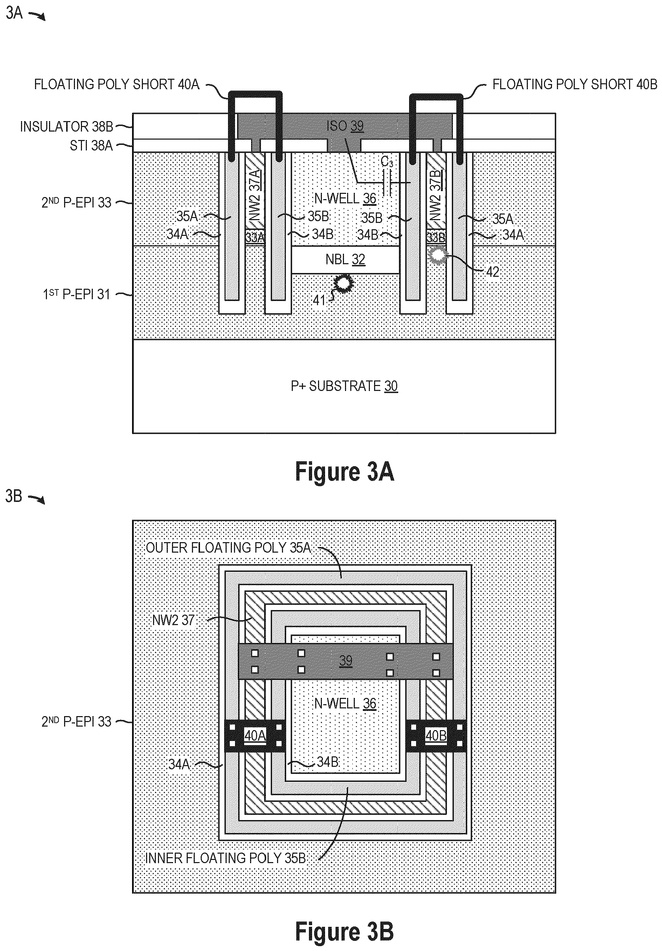

Figure 3A depicts a simplified cross-sectional view of an integrated circuit employing a first high voltage tub structure having a pair of electrically-shorted concentric poly filled trenches which separate and define an outer conductive well ring which is shorted to an inner conductive well region in accordance with selected embodiments of the present disclosure.
Figure 3B depicts a simplified plan view of the integrated circuit shown in Figure 3A in accordance with a first example embodiment of the conductive interconnect structures for shorting the concentric poly filled trenches and for separately shorting the outer conductive well ring and inner conductive well region in accordance with selected embodiments of the present disclosure.

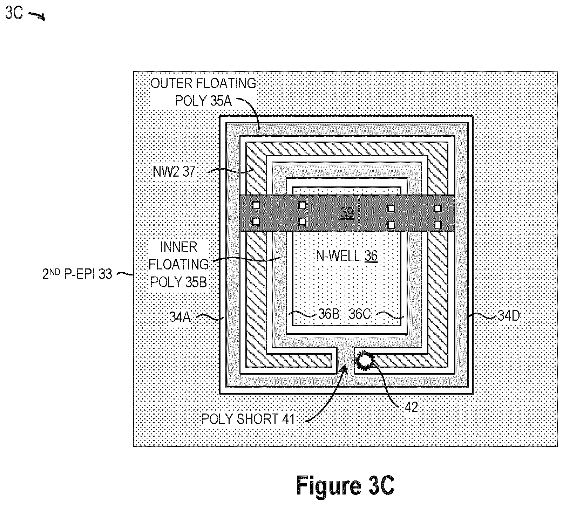

Figure 3C depicts a simplified plan view of the integrated circuit shown in Figure 3A in accordance with a second example embodiment of the conductive interconnect structures for shorting the concentric poly filled trenches and for separately shorting the outer conductive well ring and inner conductive well region in accordance with selected embodiments of the present disclosure.

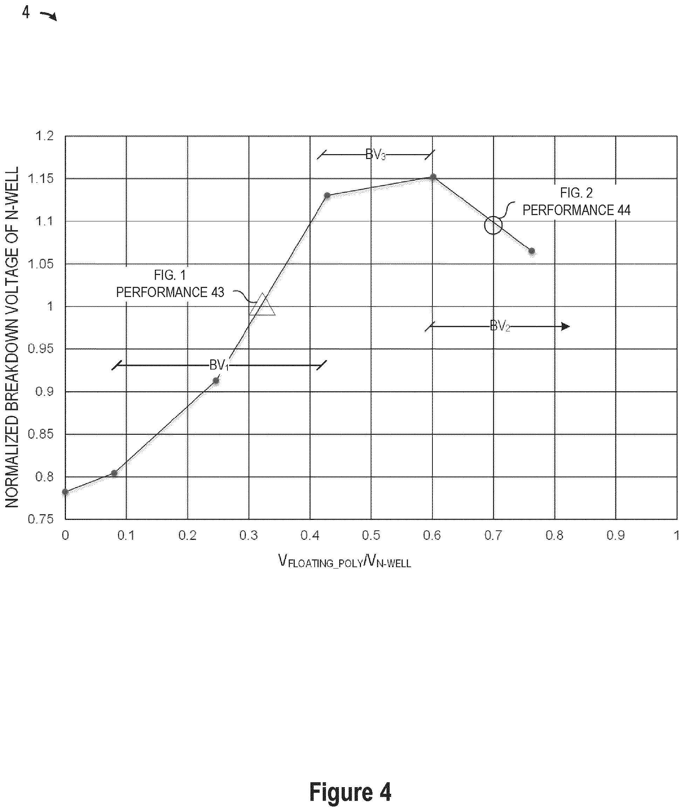

Figure 4 depicts a nanoprobe measurement plot of normalized breakdown voltages as a function of the ratio of the floating poly voltage to the conductive well voltage for purposes of evaluating different isolation structures.

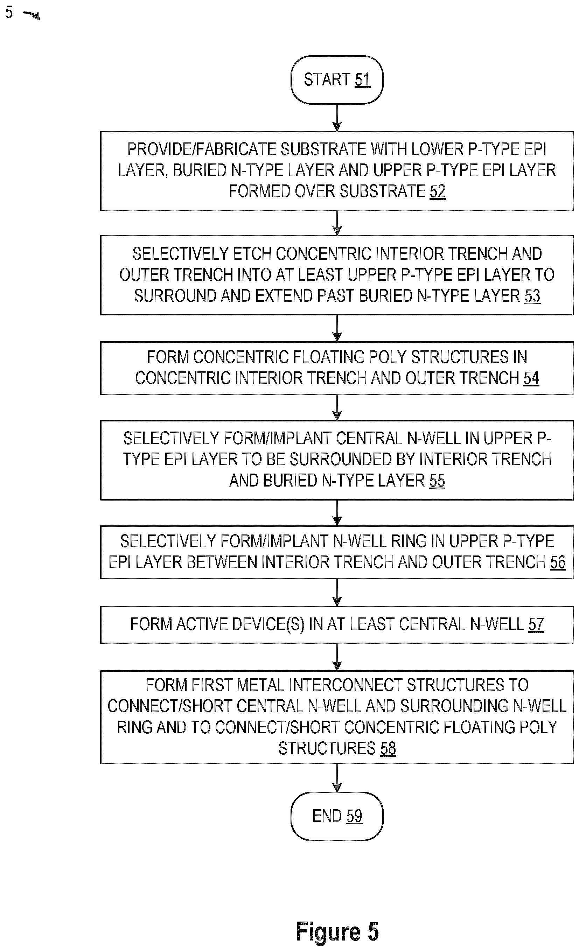

Figure 5 depicts a simplified flow chart showing the process flow for fabricating a high voltage tub having deep trench isolation provided by shorting concentric poly trenches and an outer N-well ring which is shorted to an inner N-well region in accordance with selected embodiments of the present disclosure.

### DETAILED DESCRIPTION

A method and apparatus are described for fabricating integrated semiconductor devices with high voltage tubs or regions surrounded and protected by electrically-shorted concentric deep trench isolation rings which separate and define an outer conductive well ring which is shorted to an inner conductive well region, thereby providing optimized breakdown voltages. As disclosed, the integrated semiconductor devices include a substrate of a first conductivity type, a buried layer of a second conductivity type located over the substrate, an isolated conductive well region of the second conductivity type located over the buried layer, a first floating poly isolation trench ring located around the isolated conductive well region, a first conductive well ring region of the second conductivity type located around the first floating poly isolation trench ring, a second floating poly isolation trench ring concentrically located around the first conductive well ring region, where the first and second floating poly isolation trench rings are electrically shorted together, and where the isolated conductive well region and the first conductive well ring region are electrically shorted together.

Various illustrative embodiments will now be described in detail with reference to the accompanying figures. As described hereinbelow, the disclosed embodiments can be arranged and designed in a wide variety of different configurations. Thus, the following detailed description of various embodiments, as represented in the figures, is not intended to limit the scope of the present disclosure, but is merely representative of various embodiments. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. In addition, the various aspects of the embodiments are presented in drawings that are not necessarily drawn to scale unless specifically indicated. Furthermore, the described features, advantages, and characteristics of the invention may be combined in any suitable manner in one or more embodiments. One skilled in the relevant art will recognize, in light of the description herein, that the embodiments can be practiced without one or more of the specific features or advantages of a particular embodiment. In other instances, additional features and advantages may be recognized in certain embodiments that may not be present in all embodiments. For example, selected aspects are depicted with reference to simplified cross sectional drawings of a semiconductor device without including every device feature or geometry in order to avoid limiting or obscuring the present invention. It is also noted that, throughout this detailed description, certain materials will be formed and removed to fabricate the semiconductor structure. Where the specific procedures for forming or removing such materials are not detailed below, conventional techniques to one skilled in the art for growing, depositing, removing or otherwise forming such layers at appropriate thicknesses shall be intended. Such details are well known and not considered necessary to teach one skilled in the art of how to make or use the present invention.

As will be appreciated by those skilled in the art, semiconductor-based electronic devices are typically formed with a single substrate in which is formed a number of independent semiconductor components, such as bipolar devices, complementary MOS (CMOS) devices, and/or double diffusion (DMOS) devices (collectively, BCD devices). To ensure that each semiconductor component operates correctly, the semiconductor components are electrically isolated from one another and from the substrate using one or more isolation structures so that each component type may be formed within an isolated region of the isolation structure. For each isolation structure, lateral isolation of the isolated region is often achieved by encircling the isolated region with an insulative trench structure configured to inhibit lateral current flow from one component on the substrate to the next. Vertical isolation is achieved using junction isolation between the isolated region and the substrate. The degree to which each component is electrically isolated from surrounding components and substrate affects the maximum voltage at which the semiconductor device can operate.

The isolation voltage capability (a.k.a., breakdown voltage) of a particular isolation structure refers to the maximum voltage that an isolated region of the isolation structure may be exposed to without affecting the operation of other semiconductor components formed over the same substrate in a way that is detrimental to the operation of the entire electronic device. If the voltage of the isolated region is too great, some amount of current significantly exceeding a normal leakage current begins to flow from the isolated region to other isolated regions or the substrate, and this can cause the components in other isolated regions to malfunction and/or may cause significant power consumption or even burning of the overall device. This current, sometimes referred to as crosstalk, limits the maximum voltage that may be utilized by the device, thereby limiting the capabilities of the individual semiconductor components.

Within a particular semiconductor device, a number of factors can operate to reduce the isolation breakdown voltage of a particular isolation structure. First, as the number of components formed over a single substrate increases, the density of the individual semiconductor components on the substrate also increases, and this, in turn increases the density of isolation trenches formed around the components. With isolation trenches typically being formed with an oxide or insulator liner layer that is deposited by chemical vapor deposition (CVD) or thermal oxidation, increases in the isolation trench density requires that large surface area be coated evenly with oxide/insulator materials to provide the desired isolation, but process limits on depositing oxide/insulator materials may result in non-uniform oxide/insulator liner thicknesses which can reduce the isolation breakdown voltage for the device. As a result, increasing component density can reduce the isolation breakdown voltage capability of the semiconductor devices. Another factor which adversely affects the isolation breakdown voltage for a particular isolation structure is temperature stresses over the operational lifetime of the component. For example, during high-temperature operating conditions, the isolation breakdown voltage of a relatively dense-structure device can be reduced due to charge injection and capture occurring in the polysilicon-oxide-silicon structure of the isolation trenches, thereby causing device failure.

To provide additional details for an improved contextual understanding of the present disclosure, reference is now made to Figure 1 which depicts a simplified cross-sectional view of an integrated circuit device 1 employing a first prior art isolation structure wherein an n-well region 16 is electrically isolated by a single conductive buried layer 12 which intersects with a poly-filled deep trench 14-15 that is formed in a substrate 10-11. In the isolated n-well region 16, a number of semiconductor devices, wells, or other structures may be formed. In addition, one or more metal interconnect layers are used to form an isolation connector 18 which makes direct electrical contact with the isolated n-well region 16 through patterned insulator layer(s), such as a patterned shallow trench isolation (STI) layer 17A and/or patterned insulator layer 17B. As will be appreciated, the details of the devices located in the isolated n-well region 16 have been omitted from the drawings since these details are not important to the present disclosure. In general, one or more of a transistor, a resistor, a diode, a capacitor and the like, and combinations thereof, may be formed within the isolated n-well region 16.

As depicted, the substrate 10-11 may include a first P+ substrate layer 10 and a first P-EPI region 11 formed on the first P+ substrate layer 10, where the first P-EPI region 11 includes exterior regions outside the floating poly trenches 14A/15A, 14B/15B and a central region positioned below the isolated n-well region 16. In addition, an N-type buried layer (NBL) 12 is formed in the substrate 10-11 over the central region of first P-EPI layer 11. In addition, the isolated n-well region 16 is formed over the NBL 12, alone or in combination with peripheral N-type regions (not shown) that may be electrically interconnected. To electrically isolate the n-well region 16, polysilicon structures 15A, 15B are disposed into trenches which have been lined with an oxide or insulator liner layer(s) 14A, 14B, respectively. In addition to providing structural support to the isolation structure, the polysilicon structures 15A, 15B provide protection from environmental shock, such as result from thermal expansion of isolation structure during operation of one or more of the semiconductor devices formed over substrate layer 10-11.

Before or after the formation of NBL 12 and poly-filled deep trench 14-15 in the substrate 10-11, a selective implantation process may be used to form the isolated n-well region 16 which can be used to build components and/or circuitry. As such, there may be a number of N-type and/or P-type regions formed within the isolated n-well region 16 after the desired components and/or circuitry are formed. As a result of laterally and vertically isolating the n-well region 16 by the poly-filled deep trench 14-15 and the NBL 12, semiconductor components formed on the isolated n-well region 16 can operate without interference with or from the operation of other nearby components. In particular, lateral isolation (i.e., electrical isolation from other components formed over substrate 10-11) is generally provided to the isolated n-well region 16 by the poly-filled deep trenches 14-15 formed about the semiconductor components. In addition, vertical isolation (i.e., electrical isolation from substrate 10-11) is generally provided to the isolated n-well region 16 by the NBL 12, specifically the junction between the NBL 12 and the first P-EPI layer 11. The junction between the NBL 12 and the first P-EPI layer 11forms a PN junction that is generally reverse-biased, providing electrical isolation to isolated n-well region 16 up to the isolation breakdown voltage of the component. In such a configuration, the lateral isolation provided by the poly-filled deep trenches 14-15 provides more effective isolation than the vertical isolation provided by the junction between the NBL 12 and the first P-EPI layer 11. Accordingly, the vertical isolation provided by the PN junction between the NBL 12 and the first P-EPI layer 1 1becomes a limiting factor for the isolation breakdown voltage of the structure. The weakest points of isolation are generally found at the hotspot regions 19. Thus, this breakdown voltage of the entire isolation structure may be referred to as the substrate breakdown voltage, or BV_{SUB}. Given a particular BV_{SUB} for the isolation structure, the structure is then given a rated isolation voltage (V_{ISO-RATED}) which, when the isolation structure is operated at V_{ISO-RATED}, provides enough margin for safe operation of the isolation structure. In an example component that may employ the structure shown in Figure 1, the breakdown voltage BV_{SUB} can be approximately about 30V higher than the rated voltage (V_{ISO-RATED}) or allowing the technology to be rated about 30V less than BV_{SUB}. Accordingly, the voltage within isolated n-well region 16 can vary from 0V to V_{ISO-RATED} V during normal component operations. It should be noted that higher BV_{SUB} values result in higher rated voltage V_{ISO-RATED} values which are desired to enable new circuit applications.

In operation, the isolated n-well region 16 and NBL 12 both operate at a first potential (e.g., V1) that is provided by the isolation connector 18, while the substrate 10-11 is set to a second potential (e.g., V2 or ground). With the floating poly trenches 14, 15 having a floating potential, V_{FLOATING_POLY}, the potentials of polysilicon structures 15A/15B are free to float and become coupled to a potential influenced by V1 and V2, where the coupling is analogous to coupling capacitance Ci between the floating poly structure 15 and the isolated n-well region 16. For example, if V1 is equal to V_{ISO-RATED} for a conventional device and V2 is equal to 0V, the voltage V_{FLOATING_POLY} may float to approximately 30% of V1. Accordingly, the entire voltage V_{ISO-RATED} is dropped across the weakest part of the isolation structure at hotspot locations 19. For the trench-based isolation structure depicted in Figure 1, the hot spot locations 19 are limited by the poly potential value which is affected by the relatively small capacitive coupling Ci between the poly structures 15 and the isolated n-well region 16.

To provide additional details for an improved contextual understanding of the present disclosure, reference is now made to Figure 2 which depicts a simplified cross-sectional view of an integrated circuit device 2 employing a second prior art isolation structure wherein an n-well region 26 is electrically isolated by a single conductive buried layer 22A-C which intersects with a plurality of concentric poly-filled deep trench rings 24A/25A, 24B/25B that are formed in a substrate 20-21 to surround an isolated n-well region 26. In the isolated n-well region 26, a number of semiconductor devices, wells, or other structures may be formed. Again, the details of the devices located in the isolated n-well region 26 have been omitted from the drawings since these details are not important to the present disclosure. In addition, one or more metal interconnect layers are used to form an isolation connector 28 which makes direct electrical contact with the isolated n-well region 26 through patterned insulator layer(s), such as a patterned STI layer 27A and/or patterned insulator layer 27B.

As depicted, the substrate 20-21 may include a first P+ substrate layer 20 and a first P-EPI region 21 formed on the first P+ substrate layer 20, where the first P-EPI region 21 includes exterior regions outside the concentric floating poly trenches 24A/25A, 25B/25B and a central region positioned below the isolated n-well region 26. In addition, an N-type buried layer (NBL) 22A-C is formed in the substrate 20-21 over the central region of first P-EPI layer 21 to extend across the plurality of concentric poly-filled deep trench rings 24A/25A, 24B/25B that are formed in a substrate 20-21. In addition, the isolated n-well region 26 is formed over a central portion of the NBL 22B which also includes peripheral NBL regions 22A, 22C which extend past the peripheral sides of the isolated n-well region 26. To electrically isolate the n-well region 26, a first interior polysilicon ring structure 25B is disposed in a first interior trench which has been lined with an oxide or insulator liner layer(s) 24B. In addition, a second exterior polysilicon ring structure 25A is concentrically disposed in a second exterior trench which has been lined with an oxide or insulator liner layer(s) 24A. Each additional or exterior poly-filled deep trench ring (e.g., 24A/25A) is paired with a punch-through structure which is formed with shallow implant regions 26A, 26B of the second conductivity type which are formed over regions of the first P-EPI region 21A, 21B of the first conductivity type, where the resulting punch-through structure is configured to reduce the potential subjected to the weak points of the isolation structure. In addition to providing structural support to the isolation structure, the polysilicon structures 25A, 25B provide protection from environmental shock, such as result from thermal expansion of isolation structure during operation of one or more of the semiconductor devices formed over substrate layer 20-21.

Before or after the formation of NBL 22A-C and the concentric poly-filled deep trench rings 24A/25A, 24B/25B in the substrate 20-21, one or more selective implantation processes may be used to form the isolated n-well region 26 which can be used to build components and/or circuitry. In addition, the shallow implant regions 26A, 26B may also be selectively implanted to define punch-through structures created by the junctions between regions 26A/26B and the underlying regions of the first P-EPI region 21A/21B. As a result of laterally and vertically isolating the n-well region 26 by, respectively, the concentric poly-filled deep trench rings 24A/25A, 24B/25B and the NBL 22B, semiconductor components formed on the isolated n-well region 26 can operate without interference with or from the operation of other nearby components. In addition, the punch-through structures created by the junctions between regions 26A/26B and 21A/26B operate to distribute the potential more evenly across the whole isolation structure. As such, the electrical field formed within the isolation structure is spread out across the main isolation junction beneath isolated n-well region 26 as well as the isolation junctions of the additional isolation trench rings and punch-through structures.

In operation, the isolated n-well region 26 and shallow implant regions 26A, 26B operate at a first potential (e.g., V1) that is provided by the isolation connector 28, while the substrate 20-21 is set to a second potential (e.g., V2 or ground). In this case, the center NBL portion 22B under the isolated n-well region 26, the isolated n-well region 26 and shallow implant regions 26A, 26B each share the same potential V1. However, due to the PN junctions formed by the interaction of shallow implant regions 26A, 26B with the underlying regions of the first P-EPI region 21A/21B, respectively, the potential of the peripheral NBL portions 22A, 22C are reduced by some amount below V1 to a lower potential V3.

With the floating polysilicon structures 25A, 25B being surrounded by oxide or insulator layers 24A, 24B, each have a floating potential, V_{FLOATING_POLY} which is free to float and may become coupled to a potential falling somewhere between V1 and V3 (the coupling is analogous to capacitive coupling). In this example, because of the relatively large capacitive coupling C₂, V_{FLOATING_POLY} is about 70% of V1. This causes the hotspot to move to the bottom of the trench where V_{FLOATING_POLY} and V2 potential difference leads to high electric fields.

To provide additional details for an improved understanding of selected embodiments of the present disclosure, reference is now made to Figure 3A which depicts a first simplified cross-sectional view of an integrated circuit employing a first high voltage tub structure 3A wherein an n-well region 36 is electrically isolated by a single conductive buried layer 32 and a pair of electrically-shorted concentric poly filled trenches 34A/35A, 34B/35B which separate and define an outer conductive well ring 37 which is shorted to an inner conductive n-well region 36. As depicted, the first high voltage tub structure 3A is formed in a substrate 30-31, 33 which includes a first P+ substrate layer 30, a first P-EPI region 31 formed on the first P+ substrate layer 30, and a second P-EPI region 33 formed on the first P-EPI region 31 after forming the NBL 32. The first P-EPI region 31 includes exterior regions outside the concentric floating poly trenches 34A/35A, 34B/35B and a central region positioned below the isolated n-well region 36. In addition, an N-type buried layer (NBL) 32 is formed in the substrate 30-31 over the central region of first P-EPI layer 31 to extend only between the interior poly-filled deep trench rings 34B/35B. Over the NBL 32, the isolated n-well region 36 is formed between the interior poly filled trench ring 34B/35B. In the isolated n-well region 36, a number of semiconductor devices, wells, or other structures (e.g., BJT, MOSFETs, diodes, CMOS, DMOS, etc.) may be formed, though details of the devices are not shown since these details are not important to the present disclosure.

In this configuration, the electrically-shorted concentric poly filled trenches 34A/35A, 34B/35B provide lateral electrical isolation for the inner conductive n-well region 36. And between the concentric floating poly trenches 34A/35A, 34B/35B, shallow implant regions 37A, 37B may be selectively formed as a second n-well ring region over regions of the first P-EPI region 33A, 33B to form a punch-through structure which is configured to reduce the potential subjected to the weak points of the isolation structure. In addition, vertical electrical isolation is provided by a single conductive n-type buried layer (NBL) 32 formed in the substrate 30-31, 33 to extend only between the interior poly filled trench ring 34B/35B without extending to the outer poly filled trench ring 34A/35A. In addition, one or more metal interconnect layers may be used to form an isolation connector 39 which makes direct, shorting electrical contact with the isolated n-well region 36 and the outer conductive well ring 37A/B through patterned insulator layer(s), such as a patterned STI layer 38A and/or patterned insulator layer 38B. And though shown in simplified schematic form, one or more conductive poly and/or metal interconnect layers may be used to form one or more floating poly short connectors 40A, 40B which make direct, shorting electrical contact with the poly structures 35A, 35B in the concentric poly filled trenches through the patterned insulator layer(s) 38A, 38B.

To provide a first example embodiment for shorting the outer conductive well ring 37 with the inner conductive n-well region 36 and for separately shorting the concentric floating poly filled trenches 34A/35A, 34B/35B together, reference is now made to Figure 3B which depicts a simplified plan view 3B of the first high voltage tub structure shown in Figure 3A wherein conductive interconnect structures 39, 40 are formed. While the plan view shows the -concentric floating poly filled trenches 34A/35A, 34B/35B in simplified form as having square or sharp corners, it will be appreciated that the curved geometries will be used in practice to reduce electric field effects that would otherwise arise from having sharp cornered features in the floating poly filled trenches. For example, each depicted corner feature would be formed with a defined curvature characteristic (e.g., a corner radius of 0-10 microns)

As illustrated, the conductive interconnect structure 39 may be formed with one or more metal interconnect layers to short the isolated n-well region 36 with the outer conductive well ring 37A/B by using any suitable damascene process to form or more patterned conductive interconnect layers to extend through patterned openings in the insulator layer(s) 38 to make direct, shorting electrical contact between the well regions 36, 37. While the specific arrangement, construction, and connection of the different conductive interconnect layers is not important, the conductive interconnect structure 39 may be constructed using a damascene process which deposits conductive layers in openings formed in a constituent interlayer dielectric (ILD) layer and then polishes or etches back the conductive layers to be planar with the constituent ILD layer as known to those skilled in the art. Of course, other interconnect fabrication techniques may be used to construct the different conductive interconnect layers, such as photoresist masking and plasma etching. While the illustrated conductive interconnect structure 39 is a single, continuous metal interconnect which is positioned to extend over the first high voltage tub structure 3B to make direct, shorting connections to the isolated n-well region 36 and the outer conductive well ring 37A/B, it will be appreciated that two or more metal interconnect structures may also be formed in position to short the isolated n-well region 36 and the outer conductive well ring 37A/B.

Figure 3B also illustrates an example embodiment where the conductive interconnect structure(s) 40 are may be formed with one or more metal interconnect layers to define of a pair of floating poly short connectors 40A, 40B for shorting the concentric poly filled trenches 34A/35A, 34B/35B together. As disclosed, each floating poly short connector 40A, 40B may be formed using any suitable damascene or other interconnect fabrication process to form or more patterned conductive interconnect layers to extend through patterned openings in the insulator layer(s) 38 to make direct, shorting electrical contact between the concentric poly filled trenches 34A/35A, 34B/35B. While the illustrated floating poly short connectors 40A, 40B are formed in alignment as separate metal interconnects which are each respectively positioned to make direct, shorting connections between the interior poly filled trench ring 34B/35B and the outer poly filled trench ring 34A/35A, it will be appreciated that a single, continuous metal interconnect structure may also be formed in position to short the concentric poly filled trenches 34A/35A, 34B/35B.

To provide a second example embodiment for shorting the outer conductive well ring 37 with the inner conductive n-well region 36 and for separately shorting the concentric poly filled trenches 34A/35A, 34B/35B together, reference is now made to Figure 3C which depicts a simplified plan view 3C of the first high voltage tub structure shown in Figure 3A wherein conductive interconnect structures 39, 41 are formed. In the embodiment, the conductive interconnect structure 39 may be formed with one or more metal interconnect layers to short the isolated n-well region 36 with the outer conductive well ring NW2 37 as described with reference to Figure 3B. However, instead of using metal interconnect layers to short the concentric poly filled trenches 34A/35A, 34B/35B, the shorting, electrical connection is instead provided during formation of the concentric poly filled trenches 34A/35A, 34B/35B so that one or more polysilicon shorting layers 41 are formed to electrically connect the concentric poly structures 35A, 35B. In selected embodiments, the connective polysilicon shorting layer(s) 41 may be formed by defining the deep trench openings to include an "H" type opening or layout feature which connects the interior and exterior trench openings. As a result, when the deep trench openings are filled with the conformal insulating layers 34A, 34B and floating poly structures 35A, 35B, the "H" type opening or layout feature is also filled to form the floating polysilicon shorting layer(s) 41 which connect the concentric poly structures 35A, 35B. While the illustrated floating polysilicon shorting layer(s) 41 are shown as being formed on one side a poly interconnect which is positioned to make direct, shorting connection between the concentric poly structures 35A, 35B, it will be appreciated that a two or more floating polysilicon shorting layers may be used to short the concentric poly filled trenches 35A, 35B. As will be appreciated, the geographic configuration of the "H" type floating polysilicon shorting layer(s) 41 includes sharp corners that can decrease breakdown voltage performance. Depending on the process and fabrication parameters, the sharp corners may cause a hotspot location 42 to be located between the interior and exterior floating polysilicon structures 35A, 35B just below the shallow implant regions 37A, 37B.

However the shorting connections are made, the isolated n-well region 36, shallow implant regions 37A, 37B, and NBL 32 operate at a first potential (e.g., V1) that is provided by the isolation connector 39, while the substrate 30-31, 33 is set to a second potential (e.g., V2 or ground). In addition, the electrically-shorted concentric poly filled trenches 34A/35A, 34B/35B operate at a shared floating poly voltage V_{FLOATING_POLY} which is approximately 50% of V1. As a result of optimizing the potential difference between V1 and V_{FLOATING_POLY} and V_{FLOATING_POLY} and V2, the hotspot moves to between V1 and V2 as depicted by location 41.

For an improved understanding of selected embodiments of the present disclosure, reference is now made to Figure 4 which depicts a nanoprobe measurement plot 4 of normalized NBL breakdown voltages as a function of the ratio of the floating poly voltage (V_{FLOATING_POLY}) to the isolated n-well region voltage (V_{N-WELL}) for purposes of evaluating different isolation structures. In this example, voltage measurements of breakdown voltages were conducted by nanoprobing the floating poly and n-well regions. Based on the measurement data the y-axis shows the normalized breakdown voltage BV of the isolated n-well. The x-axis shows the ratio of poly voltage and n-well voltage. For example, V_{FLOATING_POLY}/V_{N-WELL} = 0.4 means that V_{FLOATING_POLY} = 40V when the HV tub (e.g., NBL 32) = 100V.

In the depicted plot, there is a first breakdown voltage region BV₁ where the computed ratio is relatively low (e.g., V_{FLOATING_POLY}/V_{N-WELL} ≤ 0.4). In this first breakdown voltage region BVVi, a first voltage differential between the NBL and floating poly (V_{N-WELL} - V_{FLOATING_POLY}) is high, which causes the hotspot to be located next to corner at the NBL and deep trench (as shown with the hotspot 19 in Figure 1). As a result, the breakdown voltage in the first breakdown voltage region BV₁ is limited by the location of the hotspot 19 at the corner or interface of the NBL and floating poly trench where it can contribute to poly injection and trench oxide charging. Based on high voltage tub breakdown voltage values, it can be determined that the first prior art isolation structure shown in Figure 1 has a breakdown voltage which is shown to be normalized to 1, as indicated at plot point 43 where the floating poly is coupled to the HV tub at a computed ratio of approximately 30-35%.

The depicted plot also shows a second breakdown voltage region BV₂ when the computed ratio is relatively high (e.g., V_{FLOATING_POLY}/V_{N-WELL} ≥ 0.6). In this second breakdown voltage region BV₂, a second voltage differential between the floating poly and the substrate (V_{FLOATING_POLY} - V_{SUBSTRATE}) is high, which causes the hotspot to be located near bottom of the trench (as shown with the hotspot 29 in Figure 2). As a result, the breakdown voltage in the second breakdown voltage region BVV₂ is limited by the location of the hotspot 29 at the bottom of the floating poly trench at the interface with the underlying substrate (e.g., P-EPI layer 21) where it can contribute to poly injection and trench oxide charging. Based on high voltage tub breakdown voltage values, it can be determined that the second prior art isolation structure shown in Figure 2 has a breakdown voltage of about 10% higher than first prior art isolation structure shown in Figure 1, as indicated at plot point 44 where the floating poly is coupled to the HV tub at a computed ratio of approximately 65-70%.

As can be seen from the depicted plot, neither the first or second breakdown voltage regions BV₁, BV₂ obtain the optimum or highest breakdown voltage. Instead, there is a third breakdown voltage region BV₃ which is actually achieved when the ratio of V_{FLOATING_POLY}/V_{N-WELL} is between 0.4 and 0.6. In this third or optimal breakdown voltage region BV₃, the first and second voltage differentials converge to a common value, which causes the hotspot to be located near the bottom of NBL, (as shown with the hotspot 41 in Figure 3) where hot carriers are less likely to contribute to poly injection and trench oxide charging. As a result, the breakdown voltage in the third breakdown voltage region BV₃ is limited by the voltage differential between the NBL and the substrate where the floating poly is coupled to the HV tub at a computed ratio of approximately 50-60%.

In accordance with the present disclosure, optimized breakdown voltage performance may be achieved by designing the placement and well depth of the shallow implant regions 37A, 37B in relation to the placement and depth of the shorted concentric floating poly trenches 34A/35A, 34B/35B so that 0.5 ≤ V_{FLOATING_POLY}/V_{N-WELL} ≤ 0.6. As a result, a voltage of 50V applied to the isolated n-well region 36 will result in a potential of ~25V being applied to the floating poly structures 35A, 34B/35B.

To provide additional details for an improved understanding of selected embodiments of the present disclosure, reference is now made to Figure 5 which depicts a simplified flow chart showing the process flow 5 for fabricating a high voltage tub having deep trench isolation provided by shorting concentric poly trenches and an outer N-well ring which is shorted to an inner N-well region. In describing the fabrication process flow 5, various reference numbers, doping types and concentrations are provided by way of examples of different regions that can be formed, but this is intended merely to facilitate understanding of various exemplary embodiments and not by way of limitation. After the process starts at step 51, a sequence of sequence of fabrication steps 52-58 are performed to fabricate a wafer containing multiple dice, where each die includes a single substrate having one or more high voltage tub isolation structures in which is formed a number of independent semiconductor components, such as bipolar devices, CMOS devices, and/or DMOS devices. As will be appreciated, the specific sequence of steps may be modified or changed. In addition, certain steps may be implemented with a plurality of separate processing steps, may be omitted and/or performed separately.

In step 52, a substrate is provided or fabricated with a lower p-type epitaxial layer, buried n-type layer, and upper p-type epitaxial layer formed over the substrate. With respect to the fabrication step 52, a number of steps may be used, starting with preparing a semiconductor substrate having a first conductivity type (e.g., p-type) and doping concentration (e.g., ranging between 1e15-1e19 cm⁻³) for subsequent processing. On the substrate, a first epitaxial semiconductor layer of the first conductivity type (e.g., 31) is formed, such as by epitaxially growing and planarizing a first, lightly doped p-type layer over the substrate to a predetermined thickness (e.g., approximately 3-30 um) and doping concentration (e.g., approximately 1e15-1e18 cm⁻³). On the first epitaxial semiconductor layer, a patterned buried layer (e.g., 32) may be formed to be located in the area(s) of the intended high voltage tub region(s). As formed, the patterned buried layer has a second conductivity type (e.g., n-type) and a predetermined doping concentration (e.g., 1e17-1e20 um) and/or thickness. In forming the patterned buried layer, selective masking and implantation or diffusion techniques may be used, or alternatively selective epitaxial growth may be used with controlled doping conditions to form the patterned buried layer. Subsequently, a second epitaxial semiconductor layer of the first conductivity type (e.g., 33) is formed over the first epitaxial semiconductor layer to cover the patterned buried layer, such as by epitaxially growing and planarizing a second, lightly doped p-type layer to a predetermined thickness (e.g., approximately 3-30 um) and doping concentration (e.g., approximately 1e15 - 1e18 cm⁻³). Alternatively, a single p-type epitaxial semiconductor layer may be formed over the substrate, followed by implantation of n-type impurities and subsequent annealing to form an n-type buried layer.

In step 53, the substrate is selectively etched to form concentric interior trench and outer trench openings formed in at least the upper p-type epitaxial layer to surround and extend past the buried n-type buried layer. With respect to the fabrication step 53, a number of steps may be used, such as by forming patterned masks (not shown) on the substrate to define etching openings where the concentric interior and outer trenches will be formed and positioned in relation to the subsequently formed isolated n-well and surrounding n-well ring regions. Subsequently, a selective etch process can include using the patterned photoresist mask to perform one or more deep reactive-ion etching (RIE) steps having suitable etch chemistry properties to remove exposed portions of at least the upper p-type epitaxial layer to a sufficient depth that the concentric interior trench and outer trench openings extend past the buried n-type buried layer. In selected embodiments, the etch process may be controlled to form trench openings that extend 2 -10 um below the bottom junction depth of the buried n-type layer.

In step 54, concentric floating poly structures are formed in the concentric interior trench and outer trench openings to define at least a portion of an isolated region of the isolation structure. With respect to fabrication step 54, a number of steps may be used to form the floating poly structures, such as by depositing a conformal thick isolation layer on the sidewalls of the concentric interior trench and outer trench openings. In selected embodiments, the thick isolation layer may be formed with oxide, nitride, or a combination of both to a controlled thickness. Subsequently, the remaining portions of the concentric interior trench and outer trench openings are filled with a conductive filling material, such as by depositing a highly doped polysilicon plug to fill the trench openings. If needed, one or more processing steps may be applied to planarize the concentric floating poly structures with the remainder of the substrate, such as by applying a polish step to the surface of the substrate. As will be appreciated, the concentric floating poly structures may be formed and positioned to surround and protect a first isolated n-well region wherein the BCD devices will subsequently be formed. In addition, one or more shallow trench isolation structures may be formed over the substrate and concentric floating poly structures by patterning and etching shallow trench openings in the upper surface of the substrate, filling the openings with one or more insulating dielectric layers, and then polishing or planarizing the filling layers down to the surface of the substrate to form the shallow trench isolation (STI) structures over the concentric floating poly structures.

In step 55, a central n-well is formed in the upper p-type epitaxial layer to be surrounded by the floating poly structure in the interior trench and the buried n-type layer, either before or after forming the concentric floating poly structures. With respect to the fabrication step 55, a number of steps may be used to form the central n-well in the upper p-type epitaxial layer, such as by using any suitable pattern, mask, and implantation steps. For example, a first implant mask may be formed over the substrate with a defined opening which exposes the region of the upper p-type epitaxial layer that is surrounded by the interior trench where the interior floating poly structure is located. Subsequently, a selective implantation process may be applied to form the high voltage n-well region 36 in the p-epi layer 33 so as to be completely contained within the interior trench where the interior floating poly structure is located. For example, the selective implantation process may implant n-type impurities at a predetermined density and energy to define the HV n-well 36 to a depth that extends down to the n-type buried layer 32.

In step 56, an n-well ring is formed in the upper p-type epitaxial layer to be located between the interior trench and outer trench and to surround the central n-well, either before or after forming the central n-well. With respect to the fabrication step 56, a number of steps may be used to form the n-well ring in the upper p-type epitaxial layer, such as by using any suitable pattern, mask, and implantation steps. For example, a second implant mask may be formed over the substrate with a defined opening which exposes the region of the upper p-type epitaxial layer between the interior trench and the outer trench where the floating poly structures are formed. Subsequently, a selective implantation process may be applied to form the n-well ring 37 in the p-epi layer 33 so as to be located between the interior trench and outer trench where the floating poly structures are located. For example, the selective implantation process may implant n-type impurities at a predetermined density and energy to define the shallow implant regions 37A, 37B to a depth that extends partially, but not completely, down to the n-type buried layer 32. In other embodiments, the selective implantation process may implant the shallow implant regions 37A, 37B to a depth that that is 20-80% of the interior and outer trench depths.

In step 57, one or more active devices are formed in at least the central n-well region. With respect to the fabrication step 57, a number of steps may be used to form the active device(s), such as additional well regions, gate electrodes, and associated source/drain regions, on the surface of the central n-well. For example, well regions may be formed by doping the upper p-type epitaxial layer with any suitable dopant implantation procedure to define a n-type or p-type well regions. In addition, gate electrodes may be selectively formed by depositing, patterning, and etching a conductive polysilicon layer formed over one or more gate dielectric layers, and then used with one or more selective masks to implant the source and/or drain regions. As will be appreciated, other device regions, such as shallow trench insulators or resistors, may also be formed at this time.

In step 58, one or more metal interconnect structures are formed over the upper p-type epitaxial layer to electrically connect and short together the central n-well and the surrounding n-well ring, and to electrically connect and short together the concentric floating poly structures formed in concentric interior and outer trenches. With respect to the fabrication step 58, a number of steps may be used to form the metal interconnect structure(s), such as by using a damascene process to form or more patterned conductive interconnect layers 39, 40 to extend through patterned openings in the insulator layer(s) 38 to make direct, shorting electrical contact between the well regions 36, 37 or between the floating poly structures 35A, 35B. The processing at step 58 may also form interconnect paths with defined silicide layers and connecting metallization conductors (MC) which are formed in a stack of dielectric layers to make direct, shorting electrical contact between the well regions 36, 37 or between the floating poly structures 35A, 35B.

At step 59, the fabrication methodology 5 ends. At this point, the fabrication of the semiconductor device may continue with singulation into individual integrated circuit die and additional packaging steps. Of course, the order of the acts described above may vary to form specific device regions and features needed for any particular integrated circuit application. It will be appreciated that additional processing steps will be used to fabricate the semiconductor device described herein, such as a nitride strip process, preparation and formation of one or more sacrificial oxide layers, shallow trench isolation regions, and formation of various buried well or regions. In addition, other circuit features may be formed on the wafer structure, such as capacitors, diodes, etc. As examples, one or more sacrificial oxide formation, stripping, isolation region formation, well region formation, gate dielectric and electrode formation, extension implant, halo implant, spacer formation, source/drain implant, heat drive or anneal steps, and polishing steps may be performed, along with conventional backend processing (not depicted), typically including formation of multiple levels of interconnect that are used to connect the transistors in a desired manner to achieve the desired functionality. Thus, the specific sequence of steps used to complete the fabrication of the semiconductor structures may vary, depending on the process and/or design requirements.

By now, it should be appreciated that there has been provided an integrated circuit having a high voltage tub and associated method of fabrication. As disclosed, the method includes forming a buried layer of a first conductivity type (e.g., n-type) in a substrate of a second conductivity type (e.g., p-type). In selected embodiments, the buried layer extends only below the central region and does not extend laterally past the first floating isolation trench. As disclosed herein, the term "laterally" generally refers to being located at a side position or in a direction away from a midline in a plane that is parallel with a major generally planar surface of the substrate. The method also includes forming a central region of the first conductivity type in the substrate in contact with the buried layer. In addition, the method includes forming a first floating isolation trench in the substrate to surround the central region and to extend down to and surround the buried layer. The method also includes forming a second floating isolation trench in the substrate around the first floating isolation trench. In selected embodiments, the first and second floating isolation trenches are each formed with a polysilicon structure formed in an insulating liner layer. In other embodiments, the first and second floating isolation trenches are formed as a first interior polysilicon ring structure disposed around the central region, and a second exterior polysilicon ring structure concentrically disposed around the first interior polysilicon ring structure. In addition, the method includes forming a shallow ring region of the first conductivity type in the substrate between at least a portion of the first floating isolation trench and a portion of the second floating isolation trench. In selected embodiments, the shallow ring region extends at least partially down to the buried layer, and the first and second floating isolation trenches both extend into the substrate past the buried layer. The method also includes forming a first conductive interconnect structure for electrically shorting the central region to the shallow ring region. In addition, the method includes forming a second conductive interconnect structure for electrically shorting the first floating isolation trench to the second floating isolation trench. In selected embodiments, the central region is electrically shorted to the shallow ring region by the first conductive interconnect structure formed with a metal interconnect structure formed over the substrate to electrically connect the central region to the shallow ring region. In other embodiments, the first and second floating isolation trenches are electrically shorted by the second conductive interconnect structure formed with a metal interconnect structure formed over the substrate to electrically connect the first floating isolation trench to the second floating isolation trench. In other embodiments, the first and second floating isolation trenches are electrically shorted by the second conductive interconnect structure formed with an insulated polysilicon interconnect structure formed in the substrate to electrically connect the first floating isolation trench to the second floating isolation trench.

In another form, there is provided an integrated circuit device with a high voltage tub and associated method of fabrication. As disclosed, the integrated circuit device includes a substrate of a first conductivity type and a buried layer of a second conductivity type located over the substrate. In addition, the integrated circuit device includes a central isolated region of the second conductivity type located over the buried layer. In selected embodiments, a bipolar transistor device, a CMOS transistor device, and a DMOS transistor device are located at least partially within the central isolated region. The integrated circuit device also includes a first floating poly isolation structure located in the substrate to surround the central isolated region and to extend down to and surround the buried layer. In selected embodiments, the buried layer extends laterally only below the central isolated region and does not extend laterally past the first floating poly isolation structure. In addition, the integrated circuit device includes a second floating poly isolation structure located in the substrate around the first floating poly isolation structure. In selected embodiments, the first and second floating poly isolation structures each include a polysilicon structure formed in an insulating liner layer. The integrated circuit device also includes a shallow ring region of the second conductivity type located in the substrate between at least a portion of the first floating poly isolation structure and a portion of the second first floating poly isolation structure. In addition, the integrated circuit device includes a first conductive interconnect structure for electrically shorting the central isolated region to the shallow ring region. In selected embodiments, the central isolated region is electrically shorted to the shallow ring region by the first conductive interconnect structure formed with a metal interconnect structure formed over the substrate to electrically connect the central isolated region to the shallow ring region. The integrated circuit device also includes a second conductive interconnect structure for electrically shorting the first floating poly isolation structure to the second floating poly isolation structure. In selected embodiments, the first and second floating poly isolation structures are electrically shorted by the second conductive interconnect structure formed with a metal interconnect structure formed over the substrate to electrically connect the first floating poly isolation structure to the second floating poly isolation structure. In other selected embodiments, the first and second floating poly isolation structures are electrically shorted by the second conductive interconnect structure formed with an insulated polysilicon interconnect structure formed in the substrate to electrically connect the first floating poly isolation structure to the second floating poly isolation structure. In selected embodiments, the shallow ring region extends at least partially down to the buried layer, and the first and second floating poly isolation structures both extend into the substrate past the buried layer. In other embodiments, when the central isolated region is set to a greater than zero potential with respect to the substrate, a voltage across peripheral ends of the buried layer to the substrate is less than a voltage across a central portion of the buried layer to the substrate. In other embodiments, the shallow ring region of the second conductivity type and underlying portion of the substrate of the first conductivity type form a punch-through structure that is configured to pull-up a potential of the first floating poly isolation structure when the central isolated region is set to the greater than zero potential with respect to the substrate. Persons skilled in the art will appreciate that a punch-through structure would be composed of a first conductivity region in middle of the ring region of second conductivity type.

In yet another form, there is provided an integrated circuit device with a high voltage tub and associated method of fabrication. As disclosed, the integrated circuit device includes a p-type substrate, an n-type buried layer located over the p-type substrate, and an isolated n-type region located over the n-type buried layer, where the isolated n-type region and n-type buried layer being vertically aligned. The integrated circuit device also includes a first floating poly isolation trench concentrically disposed in the p-type substrate to surround the isolated n-type region. In addition, the integrated circuit device includes a shallow n-type well region concentrically disposed in the p-type substrate to surround the first floating poly isolation trench. The integrated circuit device also includes a second floating poly isolation trench concentrically disposed in the p-type substrate to surround the shallow n-type well region. In addition, the integrated circuit device includes a first conductive interconnect structure connected to electrically short the isolated n-type region to the shallow n-type well region. The integrated circuit device also includes a second conductive interconnect structure connected to electrically short the first floating poly isolation trench to the second floating poly isolation trench. In selected embodiments, the integrated circuit device also includes a bipolar transistor device, a CMOS transistor device, and a DMOS transistor device located at least partially within the isolated n-type region.

One or more embodiments of the present disclosure may include features recited in the following numbered clauses:
1. An integrated circuit device, comprising: a substrate of a first conductivity type; a buried layer of a second conductivity type located in the substrate; a central isolated region of the second conductivity type located over the buried layer; a first floating poly isolation structure located in the substrate to surround the central isolated region and to extend down to and surround the buried layer; a second floating poly isolation structure located in the substrate to surround the first floating poly isolation structure; a shallow ring region of the second conductivity type located in the substrate between at least a portion of the first floating poly isolation structure and a portion of the second first floating poly isolation structure; and a first conductive interconnect structure for electrically shorting the central isolated region to the shallow ring region, wherein the first floating poly isolation structure is shorted to the second floating poly isolation structure.
2. The integrated circuit device of claim 1, where the buried layer extends laterally only below the central isolated region and does not extend laterally past the first floating poly isolation structure.
3. The integrated circuit device of claim 1, where the first and second floating poly isolation structures each comprise a polysilicon structure formed in an insulating liner layer.
4. The integrated circuit device of claim 1, where the central isolated region is electrically shorted to the shallow ring region by the first conductive interconnect structure formed with a metal interconnect structure formed over the substrate to electrically connect the central isolated region to the shallow ring region.
5. The integrated circuit device of claim 1, where the first and second floating poly isolation structures are electrically shorted by the second conductive interconnect structure formed with a metal interconnect structure formed over the substrate to electrically connect the first floating poly isolation structure to the second floating poly isolation structure.
6. The integrated circuit device of claim 1, where the first and second floating poly isolation structures are electrically shorted by the second conductive interconnect structure formed with an insulated polysilicon interconnect structure formed in the substrate to electrically connect the first floating poly isolation structure to the second floating poly isolation structure.
7. The integrated circuit device of claim 1, where the shallow ring region extends at least partially down to the buried layer, and where the first and second floating poly isolation structures both extend into the substrate past the buried layer.
8.The integrated circuit device of claim 1, wherein, when the central isolated region is set to a greater than zero potential with respect to the substrate, a voltage across peripheral ends of the buried layer to the substrate is less than a voltage across a central portion of the buried layer to the substrate
9.The integrated circuit device of claim 1, where the shallow ring region of the second conductivity type and underlying portion of the substrate of the first conductivity type form a punch-through structure is configured to pull-up a potential of the first floating poly isolation structure when the central isolated region is set to the greater than zero potential with respect to the substrate.
10. An integrated circuit device, comprising: a substrate; an n-type buried layer located in the substrate; an isolated n-type region located over the n-type buried layer, the isolated n-type region and n-type buried layer being vertically aligned; a first floating poly isolation trench concentrically disposed in the substrate to surround the isolated n-type region; a shallow n-type well region at least partially disposed in the substrate to surround the first floating poly isolation trench; a second floating poly isolation trench concentrically disposed in the substrate to surround the shallow n-type well region; and a first conductive interconnect structure connected to electrically short the isolated n-type region to the shallow n-type well region; and wherein the first floating poly isolation trench is electrically connected to the second floating poly isolation trench.
11. The integrated semiconductor device of claim 10, wherein the first floating poly isolation trench is electrically connected to the second floating poly isolation trench by a metal interconnect structure formed over the substrate to electrically connect the first floating poly isolation trench to the second floating poly isolation trench.
12. The integrated semiconductor device of claim 10, wherein the first floating poly isolation trench is electrically connected to the second floating poly isolation trench by a polysilicon interconnect structure formed in the substrate to electrically connect the first floating poly isolation trench to the second floating poly isolation trench.
13.A method, comprising: forming a buried layer of a first conductivity type in a substrate of a second conductivity type; forming a central region of the first conductivity type in the substrate in contact with the buried layer; forming a first floating isolation trench in the substrate to surround the central region and to extend down to and surround the buried layer; forming a second floating isolation trench in the substrate around the first isolation trench; forming a shallow ring region of the first conductivity type in the substrate between at least a portion of the first floating isolation trench and a portion of the second floating isolation trench; and forming a first conductive interconnect structure for electrically shorting the central region to the shallow ring region, where the first floating isolation trench is shorted to the second floating isolation trench.
14.The method of claim 13, where the buried layer extends only below the central region and does not extend past the first floating isolation trench.
15.The method of claim 13, where the first and second floating isolation trenches each comprise a polysilicon structure formed in an insulating liner layer.
16. The method of claim 13, where the first and second floating isolation trenches comprise a first interior polysilicon ring structure disposed around the central region, and a second exterior polysilicon ring structure concentrically disposed around the first interior polysilicon ring structure.
17.The method of claim 13, where the central region is electrically shorted to the shallow ring region by the first conductive interconnect structure formed with a metal interconnect structure formed over the substrate to electrically connect the central region to the shallow ring region.
18.The method of claim 13, where the first and second floating isolation trenches are electrically shorted by the second conductive interconnect structure formed with a metal interconnect structure formed over the substrate to electrically connect the first floating isolation trench to the second floating isolation trench.
19.The method of claim 13, where the first floating isolation trench is electrically shorted to the second floating isolation trench with a polysilicon interconnect structure formed in the substrate to electrically connect the first floating isolation trench to the second floating isolation trench.
20.The method of claim 13, where the shallow ring region extends at least partially down to the buried layer, and where the first and second floating isolation trenches both extend into the substrate past the buried layer.

Although the described exemplary embodiments disclosed herein are directed to various fabrication processes and integrated circuit designs having isolation structures employing high voltage tub designs having electrically shorted concentric floating poly structures an electrically shorted isolated n-wells and surrounding shallow implant n-well rings, the present invention is not necessarily limited to the example embodiments which illustrate inventive aspects of the present invention that are applicable to a wide variety of transistor fabrication processes and/or structures. Thus, the particular embodiments disclosed above are illustrative only and should not be taken as limitations upon the present invention, as the invention may be modified and practiced in different but equivalent manners apparent to those skilled in the art having the benefit of the teachings herein. For example, while the various devices illustrated herein are for high voltage tubs formed with isolated n-well regions or the like, this is merely for convenience of explanation and not intended to be limiting and persons of skill in the art will understand that the principles taught herein apply to devices of either conductivity type. In addition, the well regions are described as being formed by implanting n-type dopants into a p-type upper semiconductor layer, but the inverse approach could instead be used by implanting p-type dopants into an n-type upper semiconductor layer, Accordingly, the identification of particular regions as N-type or P-type is merely by way of illustration and not limitation and opposite conductivity type regions may be substituted in order to form devices of opposite conduction type. Moreover, the thicknesses and doping concentrations of the described layers may be adjusted as required for the required application. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that includes a list of elements is not necessarily limited to those elements, but may include other elements not expressly listed or inherent to such process, method, article, or apparatus. The term "coupled," as used herein, is defined as directly or indirectly connected in an electrical or non-electrical manner.

As used herein, the term "semiconductor" is intended to include any semiconductor whether single crystal, poly-crystalline or amorphous and to include type IV semiconductors, non-type IV semiconductors, compound semiconductors as well as organic and inorganic semiconductors. Further, the terms "substrate" and "semiconductor substrate" are intended to include single crystal structures, polycrystalline structures, amorphous structures, thin film structures, layered structures (e.g., semiconductor-on-insulator (SOI) structures), and combinations thereof. For convenience of explanation and not intended to be limiting, semiconductor components and methods of fabrication are described herein for silicon semiconductors but persons of skill in the art will understand that other semiconductor materials may also be used.

As used herein, the term "floating" refers to an electrical condition where an integrated circuit structure (e.g., polysilicon structure) is not connected to voltage source or fixed reference, such as a ground voltage, and/or is not connected electrically to another non-floating (grounded) conductor.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. An integrated circuit device, comprising:
a substrate of a first conductivity type;
a buried layer of a second conductivity type located in the substrate;
a central isolated region of the second conductivity type located over the buried layer;
a first floating poly isolation structure located in the substrate to surround the central isolated region and to extend down to and surround the buried layer;
a second floating poly isolation structure located in the substrate to surround the first floating poly isolation structure;
a shallow ring region of the second conductivity type located in the substrate between at least a portion of the first floating poly isolation structure and a portion of the second first floating poly isolation structure; and
a first conductive interconnect structure for electrically shorting the central isolated region to the shallow ring region,
wherein the first floating poly isolation structure is shorted to the second floating poly isolation structure.

2. The integrated circuit device of claim 1, where the buried layer extends laterally only below the central isolated region and does not extend laterally past the first floating poly isolation structure.

3. The integrated circuit device of claim 1 or 2, where the first and second floating poly isolation structures each comprise a polysilicon structure formed in an insulating liner layer.

4. The integrated circuit device of any of claims 1 to 3, where the central isolated region is electrically shorted to the shallow ring region by the first conductive interconnect structure formed with a metal interconnect structure formed over the substrate to electrically connect the central isolated region to the shallow ring region.

5. The integrated circuit device of any of claims 1 to 4, where the first and second floating poly isolation structures are electrically shorted by the second conductive interconnect structure formed with a metal interconnect structure formed over the substrate to electrically connect the first floating poly isolation structure to the second floating poly isolation structure.

6. The integrated circuit device of any of claim 1 to 4, where the first and second floating poly isolation structures are electrically shorted by the second conductive interconnect structure formed with an insulated polysilicon interconnect structure formed in the substrate to electrically connect the first floating poly isolation structure to the second floating poly isolation structure.

7. The integrated circuit device of any of claims 1 to 6, where the shallow ring region extends at least partially down to the buried layer, and where the first and second floating poly isolation structures both extend into the substrate past the buried layer.

8. The integrated circuit device of any of claims 1 to 7, wherein, when the central isolated region is set to a greater than zero potential with respect to the substrate, a voltage across peripheral ends of the buried layer to the substrate is less than a voltage across a central portion of the buried layer to the substrate

9. The integrated circuit device of any of claims 1 to 8, where the shallow ring region of the second conductivity type and underlying portion of the substrate of the first conductivity type form a punch-through structure is configured to pull-up a potential of the first floating poly isolation structure when the central isolated region is set to the greater than zero potential with respect to the substrate.

10. A method, comprising:
forming a buried layer of a first conductivity type in a substrate of a second conductivity type;
forming a central region of the first conductivity type in the substrate in contact with the buried layer;
forming a first floating isolation trench in the substrate to surround the central region and to extend down to and surround the buried layer;
forming a second floating isolation trench in the substrate around the first isolation trench;
forming a shallow ring region of the first conductivity type in the substrate between at least a portion of the first floating isolation trench and a portion of the second floating isolation trench; and
forming a first conductive interconnect structure for electrically shorting the central region to the shallow ring region,
where the first floating isolation trench is shorted to the second floating isolation trench.

11. The method of claim 10, where the buried layer extends only below the central region and does not extend past the first floating isolation trench.

12. The method of claim 10 or 11, where the first and second floating isolation trenches each comprise a polysilicon structure formed in an insulating liner layer.

13. The method of any of claims 10 to 12, where the first and second floating isolation trenches comprise a first interior polysilicon ring structure disposed around the central region, and a second exterior polysilicon ring structure concentrically disposed around the first interior polysilicon ring structure.

14. The method of any of claims 10 to 13, where the central region is electrically shorted to the shallow ring region by the first conductive interconnect structure formed with a metal interconnect structure formed over the substrate to electrically connect the central region to the shallow ring region.

15. The method of any of claims 10 to 14, where the first and second floating isolation trenches are electrically shorted by the second conductive interconnect structure formed with a metal interconnect structure formed over the substrate to electrically connect the first floating isolation trench to the second floating isolation trench.
